# EUROPEAN PATENT APPLICATION

(11) **EP 0 771 886 A1**
(43) Date of publication of application: **07.05.1997**
(21) Application number: 96307864.7
(22) Date of filing: 30.10.1996
(51) Int. Cl.: C23C 16/36, C23C 16/30

(54) **Method for depositing amorphous SiNC coatings**

(30) Priority: 30.10.1995 US 550260
(71) Applicant: DOW CORNING CORPORATION, Midland Michigan 48686-0994 (US)
(72) Inventor: Loboda, Mark Jon, Midland, Michigan 48640 (US)
(74) Representative: Dowden, Marina

(57) **Abstract**

Amorphous coatings containing silicon, carbon and nitrogen are formed by the chemical vapor deposition of a reactive gas mixture comprising an organosilicon material and a nitrogen source. The process comprises introducing the reactive gas mixture into a deposition chamber containing the substrate to be coated and then inducing reaction to form the coating.

## Description

The present invention relates to the vapor deposition of coatings containing silicon, carbon and nitrogen from an organosilicon material and a nitrogen source. The resultant coatings have many desirable properties which render them useful in the electronics industry.

Numerous methods for depositing silicon containing coatings are known in the art and many are currently used in industry. For instance, it is known that silicon nitride coatings can be deposited by the chemical vapor deposition of a silane (e.g., SiH₄, H₂SiCl₂, etc.) and a source of nitrogen (e.g., nitrogen, ammonia, etc.). These coatings are taught to be valuable as protective or die1ectric coatings in the electronics industry. Such methods, however, do not incorporate carbon into the coatings.

Similarly, it is known that silicon carbide coatings can be deposited by the chemical vapor deposition of a silane (e.g., SiH₄, H₂SiCl₂, etc.) and a source of carbon (e.g., methane, ethane,etc.). These coatings, too, are useful as barriers in the electronics industry. Such methods, however, do not incorporate nitrogen into the coatings.

We have now unexpectedly found that gaseous organosilicon materials can be used in combination with nitrogen sources to form coatings containing silicon, carbon and nitrogen.

The present invention provides a method of depositing an amorphous coating containing silicon, carbon and nitrogen on a substrate. The method comprises introducing a reactive gas mixture comprising an organosilicon material and a source of nitrogen into a deposition chamber containing the substrate. The reactive gas mixture is then induced to react to form an amorphous coating containing silicon, carbon and nitrogen.

The present invention is based on our unexpected discovery that gaseous organosilicon materials can be used to form amorphous coatings containing silicon, carbon and nitrogen on various substrates. These coatings have excellent properties which render them valuable as protective and dielectric layers on substrates such as electronic devices. For instance, the coatings are exceptionally hard, approaching the hardness of diamond. In addition, the films are less likely to crack when applied to silicon substrates since the coefficient of thermal expansion of the film is greater than that of silicon. Moreover, the process of the invention is advantageous over that of the prior art in that it eliminates the need for silane which is a potential safety hazard.

The organosilicon material used in the present invention is any material having Si-C bonds which is in the gaseous state at a temperature of 500°C. or less and which will react, by the addition of energy, to add silicon and carbon to the desired coatings. Examples of specific materials include silanes having organic substituents (e.g., alkylsilanes such as methylsilane, dimethylsilane, trimethylsilane), disilanes having organic substituents (e.g., hexamethyldisilane), trisilanes having organic substituents (e.g., octamethyltrisilane), low molecular weight polysilanes having organic substituents (e.g., dimethyl polysilane), low molecular weight polycarbosilanes and silicon containing cycloalkanes such as the silacyclobutanes and disilacyclobutanes described in US Patent 5,011,706. Especially preferred is the use of trimethylsilane.

The source of nitrogen used in the present invention is any material in the gaseous state at a temperature of 500°C. or less which will react by the addition of energy to add nitrogen to the desired coatings. Examples of such materials include nitrogen, amines including primary amines such a methylamine, secondary amines such as dimethyl amines and tertiary amines such a trimethyl amine and ammonia. Especially preferred is the use of nitrogen and/or ammonia.

Naturally, other materials may also be included in the reactive gas mixture. These include, for example, carrier gases such as helium or argon; dopants such as phosphine or borane; halogens such as fluorine or any other material which would impart desirable properties to the coating.

According to our invention, the reactive gas mixture is introduced into a deposition chamber containing the substrate to be coated. If necessary, the organosilicon material and/or the nitrogen source may be heated and/or a vacuum created to convert them into the gaseous state for entry into the chamber. If heat is necessary, the materials should generally not be heated above 500°C. to prevent reaction difficulties.

The gases may be introduced into the chamber in any manner desired. For instance, the gases may be mixed prior to entry into the chamber or, alternatively, the materials may be added consecutively or via separate ports. Similarly, the gases may be introduced into the chamber followed by running the reaction (static) or, alternatively, a continuous flow of gaseous material may be introduced and removed from the chamber.

The amount of organosilicon material, nitrogen source and any other gaseous component used in the process of this invention is that which is sufficient to deposit the desired coating. This can vary over a wide range depending on factors such as the desired coating thickness, the desired rate of growth and the desired stoichiometry of the coating. Generally, the organosilicon material is present in an amount of between 1 and 90 volume percent and the nitrogen source is present in an amount of between 1 and 90 volume percent.

Generally, the reactant gases are diluted in an carrier to a volume concentration of 75% or less. Typically, the organosilicon material is used in a range between 1 and 30 vol%; the nitrogen source is used in a range between 1 and 50 vol% and the carrier is used in a range of 20 and 98 vol%.

The reactive gas mixture is then reacted to deposit the coating on the substrate. Reaction of gaseous species is well known in the art and any conventional chemical vapor deposition (CVD) technique can be used herein. For example, methods such as simple thermal vapor deposition, photothermal vapor deposition, plasma enhanced chemical vapor deposition (PECVD), electron cyclotron resonance (ECR), jet vapor deposition or any similar technique may be used. These processes involve the addition of energy (in the form of heat, plasma, etc.) to the vaporized species to cause the desired reaction.

In thermal vapor deposition, the coating is deposited by passing a stream of the reactive gas mixture over a heated substrate. When the reactive gas mixture contacts the hot surface, it reacts and deposits the coating. Substrate temperatures in the range of 100-1000°C. are sufficient to form these coatings in several minutes to several hours, depending on the thickness desired.

In PECVD, the reactive gas mixture is reacted by passing it through a plasma field. The reactive species thereby formed are then focused at the substrate and readily adhere. Generally, the advantage of this process over thermal CVD is that lower substrate temperature can be used. For instance, substrate temperatures of 20 up to 600°C. are functional.

The plasmas used in such processes comprise energy derived from a variety of sources such as electric discharges, electromagnetic fields in the radio-frequency (RF) or microwave range, lasers or particle beams. Generally preferred in most plasma deposition processes is the use of radio frequency (10 kHz to 10² MHz) or microwave (0.1 to 10 GHz) energy at moderate power densities (0.1 to 5 watts/cm²). The specific frequency, power and pressure, however, are generally tailored to the equipment.

Although the mechanism for this deposition is not clearly understood, it is postulated that the addition of energy to the reactive gas mixture causes dissociation and rearrangement of the molecules so that a silicon-carbon, silicon-nitrogen and/or carbon-nitrogen bonds are formed on the substrate. The stoichiometry of this coating is generally SiₓC_{y}N_{z}, wherein x/(y+z) is within the range of 0.8 to 1.2, preferably approaching 1, y = 0.01 to 0.99 and z = 0.99 to 0.01. Preferably, y = 0.1 to 0.9 and z = 0.9 to 0.1. The coating can also contain hydrogen in an amount between 0 and 40 atomic percent.

The process of this invention deposits desirable coatings in a wide variety of thicknesses. For instance, coatings in the range of a monolayer to greater than 2-3 micrometers are possible. The coatings are mechanically hard, have a high modulus and are excellent mechanical barriers. As such, they are useful on a wide variety of electronic devices or electronic circuits such as silicon based devices, gallium arsenide based devices, focal plane arrays, opto-electronic devices, photovoltaic cells and optical devices, as well as non-electronic substrates such as cutting tools, glass, ceramics, metals and plastics.

These coatings may also be covered by other coatings such as further SiO₂ coatings, SiO₂/modifying ceramic oxide layers, silicon containing coatings, silicon carbon containing coatings, silicon nitrogen containing coatings, silicon nitrogen carbon containing coatings, silicon oxygen nitrogen containing coatings and/or diamond like carbon coatings. Such coatings and their mechanism of deposition are known in the art. Many are taught in more detail in US Patent 4,973,526.

### Example 1

The following reactive gases were introduced into a capacitively coupled parallel plate PECVD system using silicon wafers as the substrates. Several coatings were deposited using the following array of parameters:

| | |
|---|---|
| Wafer temperature | 250°C. |
| Pressure | 200 Pa |
| RF (radio frequency) power applied to the upper electrode | 100 W |
| Total gas flow | 960 sccm |
| trimethylsilane | 6 sccm |
| Ammonia 10% in N₂ | 180-300 sccm |
| Helium | 600-775 sccm |

FTIR [Fourier Transformation Infrared Adsorption Spectroscopy] data on the resultant films shows bands at 3400 cm⁻¹ representing N-H bonds, bands at 2900 cm⁻¹ representing C-H bonds, bands at 2100 cm⁻¹ representing Si-H bonds, bands at 1600 cm⁻¹ representing C-N bonds and bands at 850 cm⁻¹ representing Si-N bonds.

The coating had a compressive stress of approximately 250 MPa which remained relatively constant over the range of gas concentrations. Stress versus temperature measurements showed a coefficient of thermal expansion greater than silicon over the range 25-250°C. and the degree of hysteresis observed in the stress versus temperature curve was very small.

### Example 2 (Comparative - Si-N coating)

The following reactive gases were introduced into a capacitively coupled parallel plate PECVD system using silicon wafers as the substrates. Several coatings were deposited using the following array of parameters:

| | |
|---|---|
| Wafer temperature | 250°C. |
| Pressure | 200 Pa |
| RF power applied to the upper electrode | 100 W |
| Total gas flow | 960 sccm |
| Silane | 60 sccm |
| Ammonia 10% in N₂ | 180-300 sccm |
| Helium | 600-775 sccm |

FTIR data on the resultant films shows a band at 3400 cm⁻¹ representing N-H bonds, a band at 2100 cm⁻¹ representing Si-H bonds and a band at 850 cm⁻¹ representing Si-N bonds.

The coating stress varied over approximately -200 MPa (tensile) to +200 MPa (compressive). Stress versus temperature measurements show a coefficient of thermal expansion less than silicon over the range 25-250°C. and the degree of hysteresis observed in the stress versus temperature curve was very small.

## Claims

1. A method of depositing an amorphous coating containing silicon, carbon and nitrogen on a substrate comprising:
introducing a reactive gas mixture comprising an organosilicon material and a source of nitrogen into a deposition chamber containing the substrate; and
inducing reaction of the reactive gas mixture to form an amorphous coating containing silicon, carbon and nitrogen.

2. The method of claim 1 wherein the organosilicon material is selected from the group consisting of methylsilane, dimethylsilane and trimethylsilane.

3. The method of claim 1 or claim 2 wherein the nitrogen source is selected from the group consisting of nitrogen and ammonia.

4. The method according to any of claims 1 to 3 wherein the reactive gas mixture also comprises a carrier gas.

5. The method according to any claims 1 to 4 wherein the reactive gas mixture is induced to react by exposure to an elevated temperature in the range of 100-1000°C.

6. The method according to any of claims 1 to 4 wherein the reactive gas mixture is induced to react by exposure to a plasma selected from the group consisting of radio frequency energy and microwave energy.

7. The method according to any of claims 1 to 6 in which the substrate comprises an electronic device.

8. A coated substrate obtainable by a method according to claims 1 to 7.

9. The method of any of claims 1 to 8 wherein the amorphous coating has the formula SiₓC_{y}N_{Z} wherein x/(y+z) is in the range of 0.8 to 1.2, y=0.01 to 0.99 and z=0.99 to 0.01.

10. The amorphous coating of claim 9 having the formula SiₓC_{y}N_{z}, wherein x/(y+z) approaches 1, y = 0.01 to 0.99 and z = 0.99 to 0.01.
